# EUROPÄISCHE PATENTSCHRIFT

(11) **EP 2 206 147 B1**
(45) Veröffentlichungstag und Bekanntmachung des Hinweises auf die Patenterteilung: **11.03.2020**
(21) Anmeldenummer: 08804055.5
(22) Anmeldetag: 11.09.2008
(51) Int. Cl.: H01L 23/40

(54) **BEFESTIGUNGSKLAMMER**
FIXING CLAMP
PINCE DE FIXATION

(30) Priorität: 25.10.2007 DE 102007050985
(43) Veröffentlichungstag der Anmeldung: 14.07.2010
(73) Patentinhaber: Robert Bosch GmbH, 70442 Stuttgart (DE)
(72) Erfinder: SCHLITTMEIER, Thomas, 84032 Altdorf (DE)
(86) Internationale Anmeldenummer: PCT/EP2008/062090
(87) Internationale Veröffentlichungsnummer: WO 2009/053159

(56) Entgegenhaltungen:
- DE-A1- 4 141 650
- DE-A1- 4 218 224
- DE-A1- 19 729 851
- DE-U1- 8 910 677
- DE-U1- 9 206 934
- US-A- 5 077 638
- US-A- 5 812 376
- US-B1- 6 587 344
- ANONYMOUS: "Produkt-Katalog 2007" [Online] 21. März 2007 (2007-03-21), FIRMA KUNZE - THE HEATMANAGEMENT COMPANY , XP002521368 Gefunden im Internet: URL:http://www.heatmanagement.com/kunze/pr odukte/kataloge/produkte.pdf> [gefunden am 2009-03-27] Seite 95 - Seite 99

## Beschreibung

### Stand der Technik

Die Erfindung betrifft ein Befestigungselement zur Befestigung eines elektronischen Bauteils an einer Fläche eines Kühlkörpers.

G 85 16 915.3 bezieht sich auf einen Kühlkörper zur Kühlung eines Halbleiterbausteins. Der Kühlkörper umfasst eine ebene Kühl-Kontaktfläche zur Kühlung eines mittels eines Federelementes an die Kühl-Kontaktfläche andrückbaren Halbleiterbausteins. Der Kühlkörper ist an der den Halbleiterbaustein tragenden Flachbaugruppe befestigt. Der Kühlkörper ist derart angeordnet und ausgebildet, dass die Kühl-Kontaktfläche senkrecht zur Ebene der Flachbaugruppe verläuft und an der der Kühl-Kontaktfläche abgewandten Seite mehrere vertikal übereinander angeordnete Kühlrippen vorgesehen sind. Am oberen Ende des Kühlkörpers ist eine etwa senkrecht zur Kühl-Kontaktfläche abstehende Blattfeder eingespannt, deren freies Ende etwa rechtwinklig zur Kühl-Kontaktfläche hin abgewinkelt ist und federnd im mittleren Bereich des dazwischen angeordneten Halbleiterbausteines anliegt.

DE 20 2005 020 760 U1 bezieht sich auf eine Anordnung, umfassend einen Kühlkörper und ein darin angeordnetes elektronisches Bauteil. Gemäß dieser Lösung umfasst die Anordnung einen Kühlkörper, ein daran angeordnetes elektronisches Bauteil und eine Federklammer zum Anpressen des Bauteiles an den Kühlkörper. Die Federklammer ist als zusätzliches Kühlelement ausgebildet. Die Federklammer wird aus einem Werkstoff hergestellt, dessen Wärmeleitfähigkeit höher ist als die Wärmeleitfähigkeit des elektronischen Bauteiles, insbesondere höher liegt als die Wärmeleitfähigkeit von Stahl, insbesondere von Federstahl.

US 5,068,764 bezieht sich auf eine Befestigungsanordnung für ein elektronisches Bauteil. Gemäß dieser Lösung wird ein elektronisches Bauteil in enganliegendem Kontakt mit einem Kühlkörper gehalten. Ein im Wesentlichen flach und länglich ausgebildetes Element hat ein freies Ende und ist so ausgebildet, dass ein elektronisches Bauteil mit einander gegenüberliegenden ersten und zweiten Flächen gegenüberliegend dem im Wesentlichen flach ausgebildeten Bauteil angeordnet werden kann. Ein Unterstützungselement erstreckt sich von dem anderen Ende eines Basiselementes mit einem Winkel von weniger als 90° bezogen auf die Ebene der Oberfläche des Basiselementes. Es ist ein Sicherungselement vorgesehen, welches eine Deformation im Trägerelement darstellt und sich vom Trägerelement in eine Position erstreckt, welche jenseits der Ebene der zweiten Flachfläche des elektronischen Bauteils liegt und so gestaltet ist, dass dieses innerhalb einer Öffnung in der Oberfläche gesichert und aufgenommen werden kann. Die Oberfläche ist eine Oberfläche eines Kühlkörpers, der im Wesentlichen parallel zu und anliegend an der zweiten Fläche des elektronischen Bauteiles ausgebildet ist.

DE 92 06 934 U1 bezieht sich auf eine Vorrichtung zur Befestigung von Bauelementen an Kühlkörpern.

DE 42 18 224 A1 bezieht sich auf eine Vorrichtung zum Befestigen mindestens eines Bauelements an einem Träger.

DE 41 41 650 A1 bezieht sich auf einen Kühlkörper mit einer abnehmbaren Andruccklammer.

US 5 812 376 A bezieht sich auf eine Befestigungsvorrichtung für elektrische Komponenten und Kühlkörpern.

DE 197 29 851 A1 bezieht sich auf die Befestigung von elektronischen Bauteilen mittels Druckfeder auf einem Aluminium-Strangpreßprofil mit einer lösbaren Schnappverbindung.

### Darstellung der Erfindung

Der Erfindung liegt die Aufgabe zugrunde, die Befestigung zwischen einem elektronischen Bauteil und einem mit diesen verbundenen Kühlkörper zu optimieren.

Erfindungsgemäß wird vorgeschlagen, das Befestigungselement, welches einen Kühlkörper mit einem zu kühlenden elektronischen Bauteil verbindet, das insbesondere als Klammer ausgeführt ist, derart zu optimieren, dass eine gleichmäßige Biegebeanspruchung über die gesamte Bauteillänge gegeben ist.

Aufgrund der Auslegung des insbesondere als Klammer ausgebildeten Befestigungselementes mit einer gleichmäßigen Biegebeanspruchung über die gesamte Bauteillänge ist ein größerer elastischer Biegebereich realisierbar. Durch einen größeren elastischen Biegebereich, welchen das Befestigungselement aufweist, das insbesondere als Klammer gestaltet ist, können mit ein und demselben Befestigungselement verschieden hohe Bauteile befestigt werden. Dies kann mit ein und demselben Bauteil erreicht werden, welches sehr kompakte äußere Abmessungen aufweist.

Zur Fixierung eines freien Endes des insbesondere als Klammer ausgebildeten Befestigungselementes wird in den Kühlkörper eine im Wesentlichen eine 90°-Orientierung zu dessen Oberflächen aufweisende Ausnehmung, beispielsweise eine Nut mit im Wesentlichen rechteckförmigem Querschnitt eingebracht. Die Nut wird bevorzugt in einer Orientierung von 90° zur Oberfläche des Kühlkörpers orientierten Lage eingefräst oder mittels eines anderen spanabhebenden Fertigungsverfahrens im Kühlkörper erzeugt. Bei dem Material des Kühlkörpers handelt es sich bevorzugt um ein metallisches Material mit hervorragenden Wärmeleiteigenschaften wie zum Beispiel Aluminium.

Aufgrund der im Wesentlichen senkrecht zu einer ersten Planfläche des Kühlkörpers orientierten Lage der mindestens einen Ausnehmung, die insbesondere als Nut ausgestaltet ist, lassen sich die Herstellkosten der Ausnehmung minimieren. Zudem kann das insbesondere als Klammer ausgebildete Befestigungselement werkzeuglos durch einfache Krafteinwirkung senkrecht zur Verrastungsrichtung gelöst werden. In vorteilhafter Weise wird dazu die Nut derart in dem Material des Kühlkörpers eingebracht, die einen im Wesentlichen rechteckförmigen Querschnitt aufweist. Die insbesondere als Nut beschaffene Ausnehmung kann einen Überstand aufweisen, insbesondere einen Vorsprung, unterhalb dessen ein freies Ende des insbesondere als Klammer ausgebildeten Befestigungselementes einrastet. Das freie Ende des insbesondere als Klammer beschaffenen Befestigungselementes weist dazu einen eingeprägten oder eingestanzten Vorsprung auf, der im eingerasteten Zustand des freien Endes des insbesondere als Klammer ausgebildeten Befestigungselementes unter dem Vorsprung an der Öffnung der Ausnehmung im Material des Kühlkörpers anliegt und verrastet ist. Zur Erleichterung der Demontage kann eine dem Vorsprung im Vollmaterial des Kühlkörpers ausgebildeten Vorsprung gegenüberliegende seitliche Begrenzungswand - nicht der Nutboden - in einer Neigung gefertigt werden und insbesondere schräg im Material des Kühlkörpers verlaufen. Durch die schräg verlaufende Begrenzungswand der insbesondere als Nut gefertigten Ausnehmung liegt eine Seite des freien Endes des insbesondere als Klammer gefertigten Befestigungselementes an der den eingeprägten oder eingestanzten Vorsprüngen gegenüberliegenden Seite des freien Endes des Befestigungselementes stets an der in einer Schrägung im Kühlkörpermaterial verlaufenden Begrenzungswand der insbesondere als Nut gefertigten Ausnehmung an. Eine Krafteinleitung in das in der insbesondere als Nut gefertigten Ausnehmung dort verrastete freie Ende des insbesondere als Klammer ausgebildeten Befestigungselementes senkrecht zur Verrastungsrichtung reicht aus, die in das freie Ende des insbesondere als Klammer gefertigten Befestigungselementes eingeprägten oder eingestanzten Vorsprünge unterhalb des Vorsprungs im Kühlkörper wegzubewegen, so dass das freie Ende entgegen der Montagerichtung in Demontagerichtung - d.h. in vertikaler Richtung nach oben - auf der Gleitfläche aus der insbesondere als Nut gefertigten Ausnehmung ausfährt.

Durch die erfindungsgemäß vorgeschlagene Lösung lassen sich am insbesondere als Klammer ausgebildeten Befestigungselement geringere Abmessungen der insbesondere als Nut beschaffenen Ausnehmung, in welche das Befestigungselement einrastet, realisieren. Kann die insbesondere als Nut gefertigte Ausnehmung kleiner dimensioniert werden, entstehen geringere Materialkosten aufgrund des abzutragenden, bevorzugt spanabhebend zu entfernenden Vollmaterials des Kühlkörpers. Es existieren der erfindungsgemäß vorgeschlagenen Lösung folgend, keine überstehenden Geometrien an einer Kontaktfläche zwischen dem zu kühlenden elektronischen Bauelement und dem Kühlkörper. Daraus resultierend lässt sich eine freie Platzierung der Bauteile realisieren, ebenso wie das Anbringen mehrerer, insbesondere als Nuten beschaffener Ausnehmungen in einer Planfläche des Kühlkörpers. Insbesondere ist das Profil des Kühlkörpers aufgrund der gerade verlaufenden, insbesondere als Nut gefertigten Ausnehmung leichter pressbar. Des Weiteren lässt sich eine leichte Demontage des bevorzugt als Klammer ausgefertigten Befestigungselementes per Hand werkzeuglos erreichen. Zum Lösen des insbesondere als Klammer ausgebildeten Befestigungselementes reicht eine einfache Krafteinleitung senkrecht zur Montagerichtung des freien Endes der Klammer in der Ausnehmung aus, um die eingeprägten oder eingestanzten, am freien Ende des insbesondere als Klammer ausgebildeten Befestigungselementes ausgebildeten Vorsprünge unterhalb der Hinterschneidung an der Eintrittsöffnung der Ausnehmung zu lösen. Des Weiteren ist das erfindungsgemäß vorgeschlagene Befestigungselement, welches insbesondere als Klammer ausgebildet ist, uneingeschränkt wiederverwendbar.

In einer vorteilhaften Ausführungsvariante des der Erfindung zugrunde liegenden Gedankens wird das Befestigungselement, insbesondere ausgebildet als Klammer, aus einem Flachmaterial gefertigt. Die Ausnehmung, insbesondere als Nut gestaltet, wird im Kühlkörpermaterial, wie zum Beispiel Aluminium, während des Strangpressens eingebracht. Das insbesondere als Klammer ausgebildete Befestigungselement weist bevorzugt zwei Hauptbestandteile auf, zum einen ein gerades Stück, welches hakenähnlich verlaufende Wölbungen umfasst, an das sich des Weiteren ein gebogener Abschnitt (Biegung) anschließt, sowie ein weiteres gerades Stück mit sich verjüngendem Auslauf. Die insbesondere als Nut ausgebildete Ausnehmung im Vollmaterial des Kühlkörpers weist eine schräg orientierte Gleitfläche für ein freies Ende des insbesondere als Klammer ausgebildeten Befestigungselementes auf, sowie einen dieser gegenüberliegend angeordneten, eine Hinterschneidung bildenden Vorsprung.

### Kurze Beschreibung der Zeichnungen

Anhand der Zeichnung wird die Erfindung nachstehend eingehender beschrieben.

Es zeigt:
- Figur 1: das erfindungsgemäß vorgeschlagene Befestigungselement, insbesondere als Klammer ausgebildet, im noch nicht montierten Zustand,
- Figur 2: das erfindungsgemäß vorgeschlagene, bevorzugt als Klammer ausgebildete Befestigungselement im montierten Zustand, und
- Figur 3: eine vergrößerte Ansicht des freien, in einer Ausnehmung eines Kühlkörpers eingerasteten Endes des insbesondere als Klammer ausgebildeten Befestigungselementes.

### Ausführungsformen

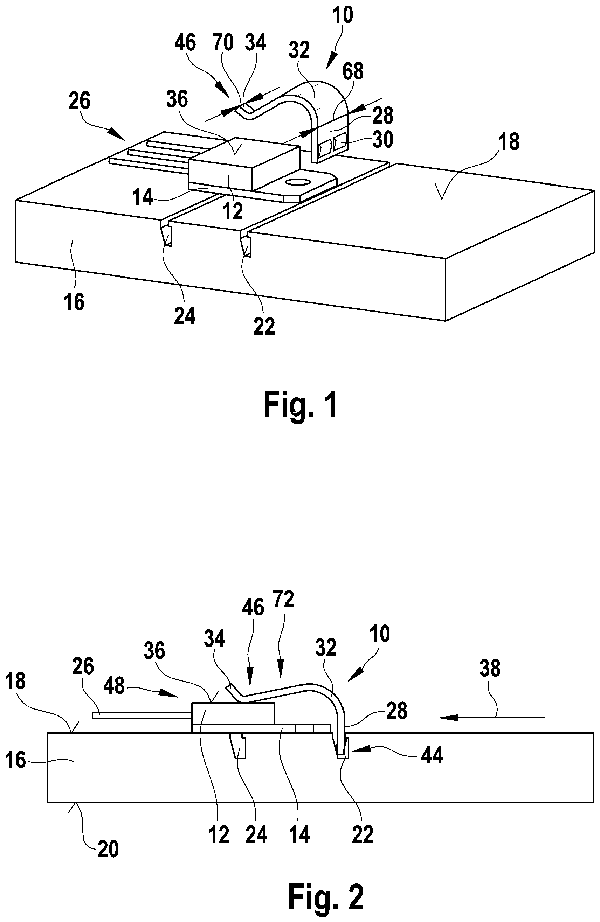

Der Darstellung in Figur 1 ist die perspektivische Ansicht eines erfindungsgemäß vorgeschlagenen Befestigungselementes, eines zu fixierenden elektronischen Bauteiles und eines Kühlkörpers zu entnehmen.

Figur 1 zeigt ein Befestigungselement 10, welches bevorzugt in Form einer Klammer ausgeführt ist. Mit dem Befestigungselement 10 wird ein elektronisches Bauteil 12, welches gegebenenfalls eine Grundplatte 14 oder dergleichen aufweisen kann, auf einer ersten Planfläche 18 eines Kühlkörpers 16 befestigt. Der Kühlkörper 16 weist neben der ersten Planfläche 18 eine zweite Planfläche 20 oder eine Verrippung oder dergleichen auf. Der Kühlkörper 16 wird bevorzugt aus einem Material mit hervorragenden Wärmeleiteigenschaften, wie zum Beispiel Aluminium, gefertigt, welches darüber hinaus recht einfach zu bearbeiten ist.

Der perspektivischen Ansicht in Figur 1 ist zu entnehmen, dass in die erste Planfläche 18 des Kühlkörpers 16 eine erste Ausnehmung 22 sowie eine zweite Ausnehmung 24 eingearbeitet sind. Die erste Ausnehmung 22, die zweite Ausnehmung 24 und gegebenenfalls weitere Ausnehmungen zur Fixierung weiterer elektronischer Bauteile 12, seien sie mit, seien sie ohne Grundplatte 14 ausgeführt, werden zum Beispiel im Wege der spanabhebenden Fertigung in Form beispielsweise von Nuten in dem Material des Kühlkörpers 16 ausgebildet oder durch Strangpressen erzeugt. Das elektronische Bauteil 12 weist eine elektrische Kontaktierung 26 auf, die zum Beispiel als Flexfolie, als Kabelstrang oder - wie in Figur 1 dargestellt - als Einzelkabelkontaktierung ausgebildet sein kann.

Wie aus Figur 1 des Weiteren zu entnehmen ist, weist das insbesondere als Klammer ausgebildete Befestigungselement 10 einen ersten, gerade verlaufenden Abschnitt 28 auf, der ein erstes freies Ende 44 des Befestigungselementes 10 bildet. In diesem ersten, gerade verlaufenden Abschnitt 28 sind - wie in Figur 1 erkennbar - in dieser Ausführung nebeneinander liegende Wölbungen oder Vorsprünge 30 ausgeführt. Bei einem Befestigungselement 10, welches aus einem metallischen Material gefertigt ist, kann der mindestens eine Vorsprung beziehungsweise die mindestens eine Wölbung 30 eingeprägt oder ausgestanzt sein. An den ersten, gerade verlaufenden Abschnitt 28 des bevorzugt als Klammer ausgebildeten Befestigungselementes 10 schließt sich eine Biegung 32 an. An die Biegung 32 wiederum schließt sich ein hinsichtlich seiner Breite verjüngender Auslauf 34 an, der ein zweites freies Ende 46 des Befestigungselementes 10 darstellt. Mit diesem wird das elektronische Bauteil 12 - wie in Figur 1 dargestellt - an einer Kontaktfläche 36 kontaktiert und gegebenenfalls unter Zwischenschaltung der Grundplatte 14 an die erste Planfläche 18 des Kühlkörpers 16 angestellt. In der Darstellung gemäß Figur 1 ist eine erste Breite des bevorzugt als Klammer ausgebildeten Befestigungselementes 10 im Bereich des ersten freien Endes 44 mit Bezugszeichen 68 bezeichnet, während eine zweite Breite 70 am verjüngten Auslauf 34 des bevorzugt als Klammer ausgebildeten Befestigungselementes 10 vorliegt.

Figur 2 zeigt eine Seitenansicht des elektronischen Bauelementes, das durch das Befestigungselement an den Kühlkörper angestellt ist.

Figur 2 ist zu entnehmen, dass die erste Ausnehmung 22 sowie die zweite Ausnehmung 24 sich in die Zeichenebene erstreckend durch den Kühlkörper 16 verlaufen. Die erste Ausnehmung 22 sowie die zweite Ausnehmung 24 weisen einen im Wesentlichen rechteckförmigen Querschnitt auf. Aus der Darstellung gemäß Figur 2 geht hervor, dass das bevorzugt als Klammer ausgebildete Befestigungselement 10 mit einem ersten freien Ende 44 und dem dort ausgebildeten mindestens einen Vorsprung 30 in die erste Ausnehmung 22 eingesteckt ist. Die zweite Ausnehmung 24 ist hingegen von der Grundplatte 14 des elektronischen Bauteiles 12, das in Position 48 an die erste Planfläche 18 des Kühlkörpers 16 angestellt ist, überdeckt. Das elektronische Bauteil 12 ist durch eine Klemmkraft 72 gehalten.

Figur 2 zeigt des Weiteren, dass das zweite freie Ende 46, welches den hinsichtlich seiner zweiten Breite 70 verjüngten Auslauf 34 umfasst, an die Kontaktfläche 36, d.h. die Oberseite des elektronischen Bauteiles 12 angestellt ist. Aufgrund der Elastizität des bevorzugt als Klammer ausgebildeten Befestigungselementes 10 wird das elektronische Bauteil 12 samt Grundplatte 14 an die erste Planfläche 18 des Kühlkörpers 16 angestellt. Wie aus Figur 2 des Weiteren hervorgeht, ist das erste freie Ende 44 des als Klammer ausgebildeten Befestigungselementes 10 einfach in die erste Ausnehmung 22 des Kühlkörpers 16 eingesteckt. Durch die Formgebung des Befestigungselementes 10 mit einem ersten gerade verlaufenden Bereich 28, der sich an diesen anschließenden Biegung 32 sowie des verjüngten Auslaufes 34, wird eine gleichmäßige Biegebeanspruchung über die gesamte Bauteillänge erreicht. Dies ermöglicht einen größeren Biegebereich, so dass auch höherbauende elektronische Bauteile als das in den Figuren 1 und 2 dargestellte elektronische Bauteil 12 mit Grundplatte 14 am Kühlkörper 16 befestigt werden können. Wie aus der Seitenansicht gemäß Figur 2 des Weiteren hervorgeht, verlaufen die erste Ausnehmung 22 sowie die zweite Ausnehmung 24 im Wesentlichen senkrecht zur ersten Planfläche 18, was die Herstellkosten der ersten beziehungsweise der zweiten Ausnehmung 22, 24 und gegebenenfalls erforderlicher weiterer Ausnehmungen günstig beeinflusst.

Das erste freie Ende 44 des bevorzugt als Klammer ausgebildeten Befestigungselementes 10 wird einfach in vertikaler Richtung nach unten ohne Zuhilfenahme eines Montage- oder eines Fixierelementes in die erste Ausnehmung 22 eingesteckt und verrastet in dieser.

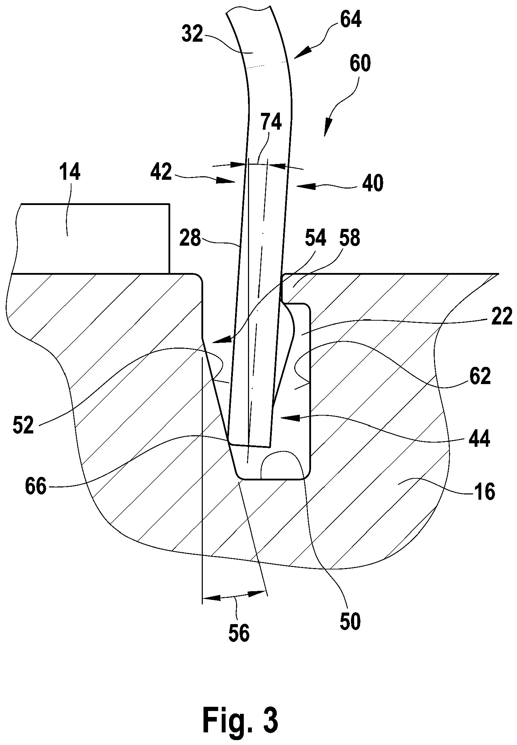

Figur 3 zeigt einen vergrößerten Ausschnitt des ersten freien Endes des bevorzugt als Klammer ausgebildeten Befestigungselementes im in der Ausnehmung des Kühlkörpers verrasteten Zustand.

Figur 3 zeigt, dass das erste Ende 44 des erste gerade verlaufenden Abschnittes 28 des bevorzugt als Klammer ausgebildeten Befestigungselementes 10 in die erste Ausnehmung 22 eingesteckt ist. Die erste Ausnehmung 22 im Kühlkörper 16 umfasst eine senkrechte Fläche 62, einen Boden 50 und eine Gleitfläche 52. Die Gleitfläche 52, die die erste Ausnehmung 22 beziehungsweise die zweite, nicht dargestellte Ausnehmung 24 begrenzt, umfasst eine Schrägung 54. Ein Schrägungswinkel 56, in dem die Schrägung 54 der Gleitfläche 52 ausgebildet ist, beträgt nur einige wenige Winkelgrade. Oberhalb der senkrechten Fläche 62 der ersten Ausnehmung 22 sowie der zweiten - zeichnerisch in Figur 3 nicht näher dargestellten Ausnehmung 24 - ist im Material des Kühlkörpers 16 ein Überstand 58 ausgeführt. Der Überstand 58 dient als Rastnase für die am ersten freien Ende 44 des ersten gerade verlaufenden Abschnittes 28 ausgebildete mindestens eine Wölbung 28. Im in Figur 3 dargestellten, in der ersten Ausnehmung 22 verrasteten Zustand des insbesondere als Klammer ausgebildeten Befestigungselementes 10 liegt entlang einer Kontaktlinie 66 das erste freie Ende 44 an der Gleitfläche 52 an. Wird das erste freie Ende 44 an einer ersten Seite 40 mit einer Kraft, die in Kraftrichtung 38 gerichtet ist, beaufschlagt, so werden aufgrund der Deformation des ersten gerade verlaufenden Abschnittes 28 die mindestens eine Wölbung 30 beziehungsweise der mindestens eine Vorsprung 30 durch den Überstand 58 freigegeben, und das erste freie Ende 44 ist aus der ersten Ausnehmung 22 entnehmbar.

Beim Einstecken des ersten freien Endes 28 in die erste Ausnehmung 22 läuft dessen Stirnseite entlang einer Kontaktlinie 66 die Gleitfläche 52 in Richtung des Bodens 50 der ersten Ausnehmung 22 hinab. Dies erfolgt so lange, bis ein Verrasten der mindestens einen Wölbung 30 beziehungsweise des mindestens einen Vorsprunges 30 unterhalb des Überstandes 58 der ersten Ausnehmung 22 erfolgt. Ein Anstellwinkel, um den das erste freie Ende 44 in der ersten Ausnehmung 22 in Bezug auf die Vertikale (90°) verkippt ist, wird durch Bezugszeichen 74 angedeutet.

Durch eine Deformation des ersten gerade verlaufenden Abschnittes 28 durch Aufbringen einer Kraft in Kraftrichtung 38 kann der erste gerade verlaufende Abschnitt 28 und damit das bevorzugt als Klammer ausgebildete Befestigungselement 10 werkzeuglos aus der ersten Ausnehmung 22 demontiert werden.

Das Befestigungselement 10, welches insbesondere als Klammer ausgestaltet ist, zeichnet sich durch geringe Abmessungen aus. Aufgrund der Formgebung des bevorzugt als Klammer ausgebildeten Befestigungselementes 10 mit einem ersten gerade verlaufenden Abschnitt 28, einer sich daran anschließenden Biegung 32 nach einem Übergang 64 sowie dem sich an die Biegung 32 anschließenden verjüngten Auslauf 34, werden dem bevorzugt als Klammer ausgebildeten Befestigungselement 10 hervorragende Biegeeigenschaften verliehen. Mit ein und demselben insbesondere als Klammer ausgebildeten Befestigungselement 10 können unterschiedlich hochbauende elektronische Bauelemente 12, seien sie mit Grundplatte 14 oder ohne Grundplatte 14 ausgeführt, auf der ersten Planfläche 18 des Kühlkörpers 16 werkzeuglos befestigt werden. Es existieren keine überstehenden Geometrien an der Kontaktfläche, d.h. an der ersten Planfläche 18 zwischen dem Kühlkörper 16 und dem auf diesen zu fixierenden elektronischen Bauteil 12 oder der Grundplatte 14. Damit kann eine freie Platzierung der elektronischen Bauelemente 10 auf der ersten Planfläche 18 erfolgen. Des Weiteren können beliebig viele Ausnehmungen 22 nebeneinanderliegend in der ersten Planfläche 18 des Kühlkörpers 16 ausgeführt werden. Aufgrund der im Wesentlichen gerade verlaufenden, insbesondere als rechteckförmige Nuten gestalteten Ausnehmungen 22 beziehungsweise 24 lässt sich das Kühlkörperprofil leichter herstellen. Verlaufen die Ausnehmungen 22, 24 im Kühlkörperprofil in einem 90°-Winkel, bezogen auf die Oberfläche des Kühlkörperprofils, ist die Fertigung desselben erheblich vereinfacht.

Wie in Zusammenhang mit den Figuren 2 und 3 bereits erwähnt, lässt sich das insbesondere als Klammer ausgebildete Befestigungselement werkzeuglos auf einfache Art und Weise durch eine an der ersten Seite 40 angreifende, in Kraftrichtung 38 gerichtete Kraft aus der ersten Ausnehmung 22 werkzeuglos demontieren. Eine zweite Seite ist durch Bezugszeichen 42 gekennzeichnet. Durch die Krafteinwirkung in Kraftrichtung 38 wird der erste gerade verlaufende Abschnitt 28 derart deformiert, dass der mindestens eine Vorsprung 30 beziehungsweise die mindestens eine Wölbung 30 durch den Überstand 58 freigegeben werden, so dass das insbesondere als Klammer ausgebildete Befestigungselement 10 leicht nach oben entnommen werden kann. Des Weiteren zeichnet sich das erfindungsgemäß vorgeschlagene, insbesondere als Klammer beschaffene Befestigungselement 10 durch eine beliebig häufige Wiederverwendbarkeit aus.

Aufgrund der Formgebung des insbesondere als Klammer ausgebildeten Befestigungselementes, insbesondere im verjüngt ausgebildeten Bereich 34, der die Kontaktfläche 36 des zu fixierenden elektronischen Bauteiles 12 kontaktiert, kann eine definierte Klemmkraft aufgebracht werden. Das insbesondere als Klammer ausgebildete Befestigungselement 10 ist darüber hinaus recht einfach als Stanzteil aus metallischem Material herzustellen. Je nachdem, wie die erste Breite 68 am ersten freien Ende 44 beziehungsweise die zweite Breite 70 am zweiten freien Ende 46 gewählt wird, können unterschiedlich breite elektronische Bauteile 12, seien sie mit Grundplatte 14, seien sie ohne Grundplatte 14 beschaffen, an der ersten Planfläche 18 des Kühlkörpers 14 fixiert werden. Es besteht die Möglichkeit, ein größeres, insbesondere ein breiterbauendes elektronisches Bauteil 12 mit oder ohne Grundplatte 14 mit mehreren erfindungsgemäß vorgeschlagenen, insbesondere als Klammer ausgebildeten Befestigungselementen 10 auf der ersten Planfläche 18 des Kühlkörpers 16 werkzeuglos zu fixieren.

Werden die erste Ausnehmung 22 beziehungsweise die zweite Ausnehmung 24 oder eine größere Anzahl von Ausnehmungen in der ersten Planfläche 18 des Kühlkörpers 16 durchgängig ausgebildet, kann nahezu die gesamte erste Planfläche 18 des Kühlkörpers 16 zur Wärmeabfuhr von elektronischen Bauteilen, wie zum Beispiel Leistungselementen oder dergleichen, genutzt werden, so dass sich eine hohe Materialausnutzung erreichen lässt.

## Patentansprüche

1. Befestigungselement (10), welches insbesondere als Klammer ausgeführt ist, zur Befestigung eines elektronischen Bauteiles (12, 14) an einer Fläche (18) eines Kühlkörpers (16), mit einem ersten freien Ende (44) und einem zweiten freien Ende (46), wobei das erste freie Ende (44) durch einen ersten, gerade verlaufenden Abschnitt (28) gebildet ist, **dadurch gekennzeichnet, dass** am ersten, gerade verlaufenden Abschnitt (28) mindestens ein Vorsprung (30) am ersten freien Ende (44) des Befestigungselementes (10) als Stanzung oder Einprägung ausgeführt ist, der in einer Ausnehmung (22, 24) des Kühlkörpers (16) unterhalb eines Überstands (58), der als Rastnase dient, lösbar verrastet ist und der erste, gerade verlaufende Abschnitt (28) durch eine senkrecht zu diesem orientierte Kraft (38) derart deformierbar ist, dass eine Rastverbindung (30, 58) in einer Ausnehmung (22, 24) gelöst wird.

2. Befestigungselement (10) gemäß Anspruch 1, **dadurch gekennzeichnet, dass** das Befestigungselement (10) eine sich an den ersten, gerade verlaufenden Abschnitt (28) anschließende Biegung (32) sowie einen sich an die Biegung (32) anschließenden verjüngten Abschnitt (34) aufweist.

3. Befestigungselement (10) gemäß Anspruch 1, **dadurch gekennzeichnet, dass** eine erste Breite (68) des ersten, gerade verlaufenden Abschnittes (28) eine zweite Breite (70) des verjüngten Auslaufes (34) des Befestigungselementes (10) übersteigt.

4. Befestigungselement (10) gemäß einem oder mehrerer der vorhergehenden Ansprüche, **dadurch gekennzeichnet, dass** der mindestens eine Vorsprung (30) auf der Seite (40) des ersten, gerade verlaufenden Abschnittes (28) ausgebildet ist, an der die Kraft (38) zum Lösen der Rastverbindung (30, 58) angreift.

5. Befestigungselement (10) gemäß einem oder mehrerer der vorhergehenden Ansprüche, **dadurch gekennzeichnet, dass** das Befestigungselement (10) aus metallischem Material gefertigt ist.

6. Befestigungselement (10) gemäß einem oder mehrerer der vorhergehenden Ansprüche, **dadurch gekennzeichnet, dass** das erste freie Ende (44) mit dem ersten, gerade verlaufenden Abschnitt (28) in einer einen im Wesentlichen rechteckförmigen Querschnitt aufweisenden Ausnehmung (22, 24) im Kühlkörper (16) werkzeuglos verrastet ist.

7. Befestigungselement (10) gemäß einem oder mehrerer der vorstehenden Ansprüche, **dadurch gekennzeichnet, dass** die Ausnehmung (22, 24) durch eine senkrechte Fläche (62) begrenzt ist, oberhalb der der Überstand (58) verläuft, und durch eine schräg verlaufende Gleitfläche (52) begrenzt ist.

8. Anordnung aus einem eine erste Planfläche (18) aufweisenden Kühlkörper (16) und einem zu kühlenden elektronischen Bauteil (12, 14), **gekennzeichnet durch** ein Befestigungselement (10) gemäß einem oder mehrerer der vorstehenden Ansprüche.

9. Anordnung gemäß Anspruch 8, **dadurch gekennzeichnet, dass** das Befestigungselement (10) mit einem verjüngten Auslauf (34) eine Kontaktfläche (36) des an die erste Planfläche (18) des Kühlkörpers (16) anzustellenden elektronischen Bauteiles (12, 14) anstellt und mit einem ersten freien Ende (44) in einer Ausnehmung (22, 24) im Material des Kühlkörpers (16) werkzeuglos fixiert ist.

10. Anordnung gemäß einem der Ansprüche 8 oder 9, **dadurch gekennzeichnet, dass** im Kühlkörper (16) mindestens eine Ausnehmung (22, 24) verläuft, die eine Gleitfläche (52) und einen Überstand (58) aufweist, wobei sich der Überstand (58) und die Gleitfläche (52) entlang der Länge der mindestens einen Ausnehmung (22, 24) im Material des Kühlkörpers (16) erstrecken.

## Claims

1. Fastening element (10), designed in particular in the form of a clamp, for fastening an electronic component (12, 14) on a surface (18) of a heat sink (16), having a first free end (44) and a second free end (46), wherein the first free end (44) is formed by a first, rectilinear portion (28), **characterized in that**, on the first, rectilinear portion (28), at least one protrusion (30) is formed, as a punched or stamped portion, at the first free end (44) of the fastening element (10) and is latched in a releasable manner in a recess (22, 24) of the heat sink (16) beneath an overhang (58), which serves as a latching nose, and the first, rectilinear portion (28) can be deformed by a force (38) oriented perpendicularly to it such that a latching connection (30, 58) in a recess (22, 24) is released.

2. Fastening element (10) according to Claim 1, **characterized in that** the fastening element (10) has a bent portion (32), which adjoins the first, rectilinear portion (28), and a tapered portion (34), which adjoins the bent portion (32).

3. Fastening element (10) according to Claim 1, **characterized in that** a first width (68) of the first, rectilinear portion (28) exceeds a second width (70) of the tapered termination (34) of the fastening element (10) .

4. Fastening element (10) according to one or more of the preceding claims, **characterized in that** the at least one protrusion (30) is formed on the side (40) of the first, rectilinear portion (28) on which the force (38) acts for the purpose of releasing the latching connection (30, 58).

5. Fastening element (10) according to one or more of the preceding claims, **characterized in that** the fastening element (10) is manufactured from metallic material.

6. Fastening element (10) according to one or more of the preceding claims, **characterized in that** the first free end (44) is latched, by way of the first, rectilinear portion (28), in a recess (22, 24) in the heat sink (16), said recess having an essentially rectangular cross section.

7. Fastening element (10) according to one or more of the preceding claims, **characterized in that** the recess (22, 24) is bounded by a vertical surface (62), above which the overhang (58) extends, and by an obliquely running sliding surface (52).

8. Arrangement made up of a heat sink (16), which has a first planar surface (18), and of an electronic component (12, 14) which is to be cooled, **characterized by** a fastening element (10) according to one or more of the preceding claims.

9. Arrangement according to Claim 8, **characterized in that** the fastening element (10) establishes contact, by way of a tapered termination (34), with a contact surface (36) of the electronic component (12, 14), which is to be positioned on the first planar surface (18) of the heat sink (16), and is fixed, by way of a first free end (44), in a recess (22, 24) in the material of the heat sink (16) without any tools being used.

10. Arrangement according to either of Claims 8 and 9, **characterized in that** the heat sink (16) contains at least one recess (22, 24), which has a sliding surface (52) and an overhang (58), wherein the overhang (58) and the sliding surface (52) extend along the length of the at least one recess (22, 24) in the material of the heat sink (16).

## Revendications

1. Élément de fixation (10), qui est réalisé notamment sous forme de pince pour la fixation d'un composant électronique (12, 14) à une surface (18) d'un puits de chaleur (16), comprenant une première extrémité libre (44) et une deuxième extrémité libre (46), la première extrémité libre (44) étant formée par une première portion s'étendant en ligne droite (28), **caractérisé en ce qu'**au niveau de la première portion s'étendant en ligne droite (28) est réalisée au moins une saillie (30) au niveau de la première extrémité libre (44) de l'élément de fixation (10), en tant qu'estampage ou gaufrage, qui est encliquetée de manière amovible dans un évidement (22, 24) du puits de chaleur (16) en dessous d'un dépassement (58) qui sert d'ergot d'encliquetage, et la première portion s'étendant en ligne droite (28) peut être déformée par une force (38) orientée perpendiculairement à celle-ci de telle sorte qu'une connexion par encliquetage (30, 58) dans un évidement (22, 24) soit desserrée.

2. Élément de fixation (10) selon la revendication 1, **caractérisé en ce que** l'élément de fixation (10) présente une partie coudée (32) se raccordant à la première portion s'étendant en ligne droite (28) ainsi qu'une portion rétrécie (34) se raccordant à la partie coudée (32).

3. Élément de fixation (10) selon la revendication 1, **caractérisé en ce qu'**une première largeur (68) de la première portion s'étendant en ligne droite (28) dépasse une deuxième largeur (70) de la sortie rétrécie (34) de l'élément de fixation (10).

4. Élément de fixation (10) selon l'une quelconque ou plusieurs des revendications précédentes, **caractérisé en ce que** l'au moins une saillie (30) est réalisée du côté (40) de la première portion s'étendant en ligne droite (28), au niveau duquel s'applique la force (38) pour desserrer la connexion par encliquetage (30, 58).

5. Élément de fixation (10) selon l'une quelconque ou plusieurs des revendications précédentes, **caractérisé en ce que** l'élément de fixation (10) est fabriqué en matériau métallique.

6. Élément de fixation (10) selon l'une quelconque ou plusieurs des revendications précédentes, **caractérisé en ce que** la première extrémité libre (44) avec la première portion s'étendant en ligne droite (28) est encliquetée sans outil dans le puits de chaleur (16) dans un évidement (22, 24) présentant essentiellement une section transversale rectangulaire.

7. Élément de fixation (10) selon l'une quelconque ou plusieurs des revendications précédentes, **caractérisé en ce que** l'évidement (22, 24) est limité par une surface verticale (62) au-dessus de laquelle s'étend le dépassement (58), et est limité par une surface de glissement (52) s'étendant obliquement.

8. Agencement constitué d'un puits de chaleur (16) présentant une première surface plane (18) et d'un composant électronique à refroidir (12, 14), **caractérisé par** un élément de fixation (10) selon l'une quelconque ou plusieurs des revendications précédentes.

9. Agencement selon la revendication 8, **caractérisé en ce que** l'élément de fixation (10), avec une sortie rétrécie (34), s'engage avec une surface de contact (36) du composant électronique (12, 14) à appliquer contre la première surface plane (18) du puits de chaleur (16) et est fixé sans outil avec une première extrémité libre (44) dans un évidement (22, 24) dans le matériau du puits de chaleur (16).

10. Agencement selon l'une quelconque des revendications 8 ou 9, **caractérisé en ce que** dans le puits de chaleur (16) s'étend au moins un évidement (22, 24) qui présente une surface de glissement (52) et un dépassement (58), le dépassement (58) et la surface de glissement (52) s'étendant le long de la longueur de l'au moins un évidement (22, 24) dans le matériau du puits de chaleur (16).
